(19) Europäisches Patentamt
European Patent Office
Office européen des brevets

(11) **EP 3 713 082 B1**

(12) **EUROPEAN PATENT SPECIFICATION**

(45) Date of publication and mention
of the grant of the patent:
**18.10.2023 Bulletin 2023/42**

(21) Application number: **20164523.1**

(22) Date of filing: **20.03.2020**

(51) International Patent Classification (IPC):
$H03F\ 3/183^{(2006.01)}$  $H03F\ 3/185^{(2006.01)}$
$H03F\ 1/02^{(2006.01)}$  $H03F\ 1/30^{(2006.01)}$
$H03F\ 1/32^{(2006.01)}$  $H03F\ 3/26^{(2006.01)}$
$H03F\ 3/30^{(2006.01)}$  $H03F\ 3/343^{(2006.01)}$
$H03F\ 3/45^{(2006.01)}$  $G05F\ 1/56^{(2006.01)}$

(52) Cooperative Patent Classification (CPC):
**H03F 3/45475; H03F 1/0205; H03F 1/307;
H03F 1/3211; H03F 1/3217; H03F 3/183;
H03F 3/1855; H03F 3/26; H03F 3/3081;
H03F 3/3435; H03F 3/45174; H03F 3/45282;
H03F 3/45372;** H03F 2200/03; H03F 2200/91;

(Cont.)

(54) **AMPLIFICATION CIRCUIT**

VERSTÄRKUNGSSCHALTUNG

CIRCUIT D'AMPLIFICATION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **22.03.2019 JP 2019054260**

(43) Date of publication of application:
**23.09.2020 Bulletin 2020/39**

(73) Proprietor: **YAMAHA CORPORATION**
**430-8650 Shizuoka Hamamatsu-shi (JP)**

(72) Inventors:
• **Hirai, Toru**
  **Shizuoka, 430-8650 (JP)**
• **Noro, Masao**
  **Shizuoka, 430-8650 (JP)**
• **Miyake, Yoshiro**
  **Shizuoka, 430-8650 (JP)**

(74) Representative: **Hoffmann Eitle**
**Patent- und Rechtsanwälte PartmbB**
**Arabellastraße 30**
**81925 München (DE)**

(56) References cited:
**EP-A1- 3 413 462**

• **FABRE A: "WIDEBAND TRANSLINEAR
CURRENT CONVERTOR", ELECTRONICS
LETTERS,, vol. 20, no. 6, 15 March 1984
(1984-03-15) , pages 241-242, XP001405869,**
• **FABRE A ET AL: "ULTRA-LOW-DISTORTION
CURRENT- CONVERSION TECHNIQUE",
ELECTRONICS LETTERS,, vol. 20, no. 17, 16
August 1984 (1984-08-16), pages 674-676,
XP001405871,**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

(52) Cooperative Patent Classification (CPC): (Cont.)
H03F 2200/93; H03F 2200/96; H03F 2203/45134

## Description

### TECHNICAL FIELD

The present invention relates to an amplification circuit using a current-current conversion circuit.

### BACKGROUND ART

As an amplification circuit of this kind, amplification circuits disclosed by JP-A-S62-214707 and JP-A-H8-32367 are known. In each of the amplification circuits, the current-current conversion circuit has four transistors that constitute a translinear circuit by using their PN junctions, and constant current sources. In further detail, the current-current conversion circuit has two complementary pairs in each of which transistors are in the complementary configuration, i.e., an NPN transistor on the higher potential side and a PNP transistor on the lower potential side are connected in series. In the case of the amplification circuit of JP-AS62-214707, the base of the NPN transistor of the first complementary pair and that of the NPN transistor of the second complementary pair are commonly connected to the collector of the NPN transistor of the second complementary pair. The emitter of the NPN transistor of the first complementary pair is connected to that of the PNP transistor of the same complementary pair, and the emitter of the NPN transistor of the second complementary pair is connected to that of the PNP transistor of the same complementary pair. The base of the PNP transistor of the first complementary pair and that of the PNP transistor of the second complementary pair are connected to the collector of the PNP transistor of the second complementary pair. The constant current sources are connected in series to the second complementary pair. In the first complementary pair, the common connection node of the emitters of the NPN transistor and the PNP transistor is set as an input node. The amplification circuit of JP-A-H8-32367 is configured basically in a similar manner. In the current-current conversion circuit, the collector currents of the NPN transistor and the PNP transistor of the first complementary pair are controlled so that the input current to the input node is equal to the difference between the collector currents, and the product of the collector currents has a constant value.

In the amplification circuit, because of a current mirror circuit, the collector current of a transistor between the output terminal of the output stage of the amplification circuit and the positive power supply is proportional to the collector current of the NPN transistor of the first complementary pair of the current-current conversion circuit. Moreover, the collector current of a transistor between the output terminal and the negative power supply is proportional to the collector current of the PNP transistor of the first complementary pair of the current-current conversion circuit. Then, the collector currents of the two transistors of the output stage are combined with each other to drive the load.

In the current-current conversion circuit of the amplification circuit, in a region where the input current is positive, in accordance with a positive direction change of the input current, the collector current of each of the PNP transistors is increased, and, on the other hand, that of each of the NPN transistors is decreased. In a region where the input current is negative, in accordance with a negative direction change of the input current, the collector current of the NPN transistor is increased, and, on the other hand, that of the PNP transistor is decreased. The product of the collector currents of the NPN transistor and the PNP transistor is always constant.

In the current-current conversion circuit, the collector current of the NPN transistor is decreased in accordance with a positive direction change of the input current, but the collector current of the NPN transistor does not become zero. In the current-current conversion circuit, the collector current of the PNP transistor is decreased in accordance with a negative direction change of the input current, but the collector current of the PNP transistor does not become zero. Even when the value of the constant current of the constant current source is set to a very low level, therefore, the transistors constituting the output stage are not cut off in the amplification operation of the amplification circuit, and the amplification circuit operates as a class-A amplification circuit.

In the current-current conversion circuit, the difference between the collector currents of the NPN transistor and PNP transistor, and the input current are linearly related that the relationship line passes through the origin. A current that is proportional to the difference flows from the output stage of the amplification circuit to the load. Therefore, the amplification circuit can realize high linearity.

Recently, complementary transistors and MOSFETs (Metal Oxide Semiconductor Field Effect Transistors) become reduced in number, and the demand for an amplification circuit having an output stage in which same-polarity elements are connected in a totem-pole configuration (hereinafter, such an output stage is referred to as a totem-pole output stage) is increasing. In an output stage of a complementary configuration, the positive and negative inputs are configured by a pair of inputs of the current sink and source types. In a totem-pole output stage, when one input is of the current sink type, by contrast, also the other input is of the current sink type, and, when one input is of the current source type, also the other input is of the current source type. In the above-described current-current conversion circuits disclosed by JP-A-S62-214707 and JP-A-H8-32367, however, output currents are vertically symmetrical to the higher and lower potential sides. In the case where the current-current conversion circuit is applied to a totem-pole output stage, therefore, there arises a need to add a current mirror circuit to only one of the NPN and PNP transistor sides of the current-current conversion circuit, thereby folding back the current. In the current-current conversion circuit, consequently, the output circuit on the side of the NPN transistors, and that on the side of the PNP transistors are asymmetrical with each other, thereby causing a problem in that the characteristics of the amplification circuit degrade. The problem will be specifically described in the description of the preferred embodiments.

From FABRE A: "WIDEBAND TRANSLINEAR CURRENT CONVERTOR", ELECTRONICS LETTERS, vol. 20, no. 6, 5 March 1984, pages 241-242 a wideband translinear current convertor is known, using a PNP-NPN translinear loop and two current mirrors. The converter has a virtual earth input.

SUMMARY

The invention has been conducted in view of the above-discussed circumstances. It is an object of the invention to provide an amplification circuit including a current-current conversion circuit which is excellent in linearity, in which the idle current is low, and which is suitable for an output stage configured by transistors of the same polarity.
The present invention is defined in the appended independent claims. Embodiments of the present invention are given in the dependent claims.

BRIEF DESCRIPTION OF THE DRAWINGS

Fig. 1 is a circuit diagram showing the configuration of an amplification circuit of a first embodiment of the invention;
Fig. 2 is a view showing collector currents of transistors of a current-current conversion circuit of the amplification circuit;
Fig. 3 is a view showing waveforms of collector currents of the transistors of the current-current conversion circuit, and the product and difference of the collector currents;
Fig. 4 is a circuit diagram showing the configuration of an amplification circuit of a second embodiment of the invention;
Fig. 5 is a circuit diagram showing a first specific example of the amplification circuit; and
Fig. 6 is a circuit diagram showing a second specific example of the amplification circuit.

DETAILED DESCRIPTION OF THE EXEMPLARY EMBODIMENTS

Hereinafter, embodiments of the invention will be described with reference to the drawings.

<First embodiment>

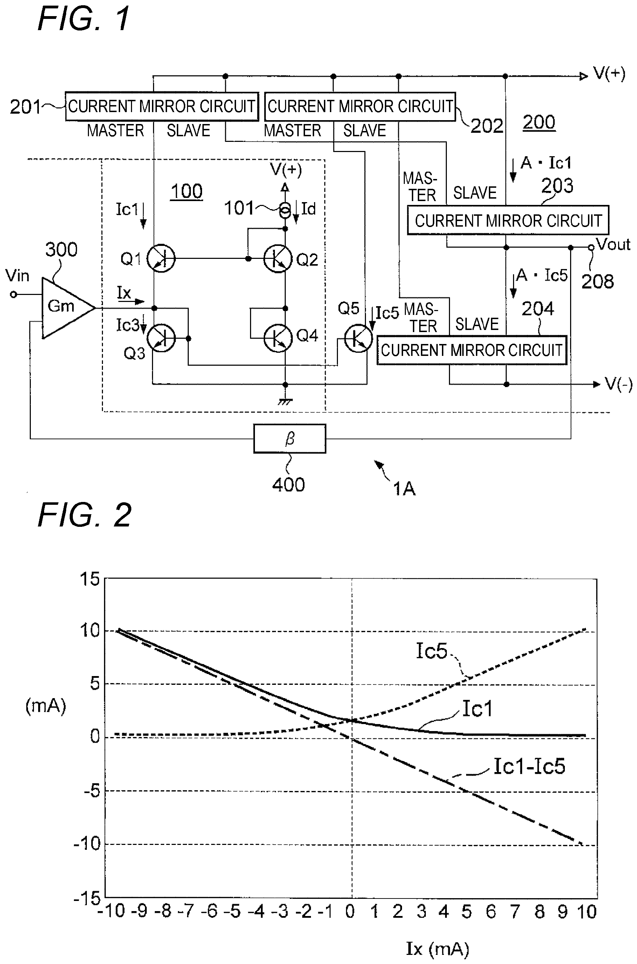

Fig. 1 is a circuit diagram showing the configuration of an amplification circuit 1A of a first embodiment of the invention. The amplification circuit 1A includes a current-current conversion circuit 100, a current generation circuit 200, a transconductance amplifier 300, and a feedback circuit 400.

The current-current conversion circuit 100 has a first transistor Q1, a second transistor Q2, a third transistor Q3, a fourth transistor Q4, and a constant current source 101 of a current value Id. The transistors Q1 to Q4 are transistors having the same characteristics and polarities. Specifically, all of the transistors Q1 to Q4 are NPN transistors.

The transistor Q2 is diode-connected, i.e., the collector and the base are connected to each other. The transistor Q3 is diode-connected, and connected in series to the transistor Q1. In the transistor Q3, specifically, the collector and the base are connected to the emitter of the transistor Q1, and the emitter is grounded. The transistor Q4 is diode-connected, and connected in series to the transistor Q2. In the transistor Q4, specifically, the collector and the base are connected to the emitter of the transistor Q2, and the emitter is grounded. The constant current source 101 is connected in series to the transistors Q2 and Q4. Specifically, the constant current source 101 is connected between the collector of the transistor Q2 and a positive power supply V(+).

In the transistors Q1 and Q2, their bases are connected to each other. Therefore, a control voltage that is common to the transistors Q1 and Q2 is applied to the transistor Q1. Both the emitters of the transistors Q3 and Q4 are grounded, and therefore the transistors Q1, Q2, Q3, and Q4 constitute a translinear circuit that forms a single loop by using only the PN junctions of the transistors. An input signal current Ix is given to the common connection node of the transistors Q1 and Q3.

The current generation circuit 200 includes current mirror circuits 201 to 204 and a transistor Q5. Currents that are proportional respectively to the currents which are input to the master sides of the current mirror circuits 201 to 204 are output to the slave sides of the current mirror circuits. In the transistors Q3 and Q5, their bases are connected to each other, and their emitters are connected to each other, thereby constituting a translinear circuit. The base current Ib3 of the transistor Q3 is sufficiently smaller than the collector current Ic3, and the base current Ib5 of the transistor Q5 is sufficiently smaller than the collector current Ic5 (even in a very usual element, about one hundredth or less). Therefore, the collector current Ic5 of the transistor Q5 becomes equal to the collector current Ic3 of the transistor Q3. In the current generation circuit 200, the current mirror circuits 201 and 203 function as the first current generating section that supplies a first current to a load based on the collector current of the first transistor Q1, and the transistor Q5 and the current mirror circuits 202 and 204 function as the second current generating section that supplies a second current to the load based on the collector current of the third transistor Q3.

The master side of the current mirror circuit 201 is connected to the collector of the transistor Q1, and the slave side is connected to the master side of the current mirror circuit 203. Therefore, a current that is proportional to the collector current Ic1 of the transistor Q1 is supplied to the master side of the current mirror circuit 203.

The master side of the current mirror circuit 202 is connected to the collector of the transistor Q5, and the slave side is connected to the master side of the current mirror circuit 204. Therefore, a current that is proportional to the collector current Ic5 of the transistor Q5 is supplied to the master side of the current mirror circuit 204.

The load such as a speaker is connected to an output terminal 208. The current mirror circuit 203 supplies a current that is proportional to the current supplied through the current mirror circuit 201, i.e., a current $A \cdot Ic1$ that is proportional to the collector current of the transistor Q1, to the output terminal 208.

The current mirror circuit 204 pulls in a current that is proportional to the current supplied through the current mirror circuit 202, i.e., a current $A \cdot Ic5$ that is proportional to the collector current of the transistor Q5, from the output terminal 208.

Therefore, a current corresponding to the difference between the current $A \cdot Ic1$ that is output from the current mirror circuit 203, and the current $A \cdot Ic5$ that is output from the current mirror circuit 204 flows through the load.

Since, as described above, the collector current Ic5 of the transistor Q5 is equal to the collector current Ic3 of the transistor Q3, the current generation circuit 200 supplies a current corresponding to the difference between the first current $A \cdot Ic1$ and the second current $A \cdot Ic5$, to the load based on the collector current of the first transistor Q1, and the collector current of the third transistor Q3.

The transconductance amplifier 300 supplies a current signal Ix that is proportional to the differential input voltage, as the input signal to the common connection node of the transistors Q1 and Q3, i.e., the input node of the current-current conversion circuit 100. Because of the feedback circuit 400, the output signal Vout that is generated at the output terminal 208 is negatively fed back at a feedback factor β to the transconductance amplifier 300, and therefore the amplification circuit 1A constitutes a non-inverting amplification circuit.

Next, the operation of the embodiment will be described. In the current-current conversion circuit 100, the transistors Q1 to Q5 having the same characteristics are thermally coupled with one another, and operate so that the base-emitter junctions are forward biased. When, under this state, the base-emitter voltages of the transistors Q1 to Q4 are indicated by Vbe1 to Vbe4, respectively, the following equation holds in accordance with the Kirchihoffs voltage law in the configuration shown in Fig. 1:

$$Vbe1 + Vbe3 = Vbe2 + Vbe4 \dots (1)$$

Here, there is a following relationship between the base-emitter voltage Vbe and collector current Ic in the respective transistors:

$$Vbe = K \cdot \log_e Ic \dots (2)$$

where K is a constant.

When the collector currents of the transistors Q1 to Q4 are indicated by Ic1 to Ic4, respectively, therefore, following equation (3) holds from equations (1) and (2):

$$\log_e Ic1 + \log_e Ic3 = \log_e Ic2 + \log_e Ic4 \dots (3)$$

Consequently, equation (4) holds in accordance with the logarithmic summation formula:

$$Ic1 \cdot Ic3 = Ic2 \cdot Ic4 \dots (4)$$

In the configuration shown in Fig. 1, the transistors Q2 and Q4 are connected in series to the constant current source 101 of the current value Id, and the base current Ib is sufficiently smaller than the collector current Ic. Therefore, the following equation holds:

$$Ic2 = Ic4 = Id \quad (\text{constant value}) \dots (5)$$

Therefore, the following equation holds from equations (4) and (5):

$$Ic1 \cdot Ic3 = Id^2 \quad (\text{constant value}) \dots (6)$$

On the other hands, when, in Fig. 1, the current Ix is supplied to the input node of the current-current conversion circuit 100, the base current Ib3 of the transistor Q3 is sufficiently smaller than the collector current Ic3, and hence the following equation holds in accordance with the Kirchihoffs current law:

$$Ix + Ic1 - Ic3 = 0 \dots (7)$$

Equation (6) is solved for Ic3, the resulting Ic3 is substituted into equation (7), the both sides are multiplied by Ic1, and then the equation is arranged, with the result that the following equation is obtained:

$$Ic1^2 + Ix \cdot Ic1 - Id^2 = 0 \dots (8)$$

When, equation (8) is solved for Ic1, the following equation is obtained:

$$Ic1 = \{-Ix \pm \sqrt{(Ix^2 + 4 \cdot Id^2)}\}/2 \ldots (9)$$

In the precondition, the transistors operate so that the base-emitter junctions are forward biased. Therefore, the following equation is the real solution of Ic1:

$$Ic1 = \{-Ix + \sqrt{(Ix^2 + 4 \cdot Id^2)}\}/2 \ldots (10)$$

When Ic3 is similarly obtained, the following equation is found:

$$Ic3 = \{Ix + \sqrt{(Ix^2 + 4 \cdot Id^2)}\}/2 \ldots (11)$$

In Fig. 1, moreover, the transistors Q3 and Q5 constitute a translinear circuit and the following equation holds between the base-emitter voltage Vbe3 of the transistors Q3 and the base-emitter voltage Vbe5 of the transistor Q5:

$$Vbe3 = Vbe5 \ldots (12)$$

In the transistor Q3, the base current Ib3 is sufficiently smaller than the collector current Ic3, and, in the transistor Q5, the base current Ib5 is sufficiently smaller than the collector current Ic5. From equations (2) and (12), therefore, the current Ic3 and the current Ic5 are equal to each other. Therefore, equation (6) can be rewritten as follows:

$$Ic1 \cdot Ic5 = Id^2 \text{ (constant value)} \ldots (13)$$

Therefore, the following equation holds:

$$Ic5 = \{Ix + \sqrt{(Ix^2 + 4 \cdot Id^2)}\}/2 \ldots (14)$$

Fig. 2 is a graph that shows the current Ic1 indicated in equation (10), the current Ic5 indicated in equation (14), and the value of Ic1 - Ic5 in the case where the input current Ix is changed. In Fig. 2, the current Id is 10 mA, and the input current Ix is changed from -10 mA to + 10 mA.

As shown in Fig. 2, even when one of the currents Ic1 and Ic5 is increased, the other current only approaches zero, but never is cut off. The difference Ic1 - Ic5 between the currents Ic1 and Ic5 is expressed as a linear line that passes through the origin. In the embodiment, the currents Ic1 and Ic5 are individually A (> 1) times current amplified by using the current mirror circuits 201 to 204, and the amplified currents are supplied to the output terminal 208.

In the amplification circuit 1 A of the embodiment, even when the current Id is set to a small value so that the idle current is low, as described above, transistors (not shown) that are between the positive power supply (V+) in the current mirror circuit 203 and the output terminal 208, and transistors (not shown) that are between the negative power supply (V-) and the output terminal 208 are always in the active state. According to the embodiment, that is, it is possible to realize a same-polarity SEPP (Single Ended Push-Pull) amplifier in which the idle current is low, and which performs class-A operation.

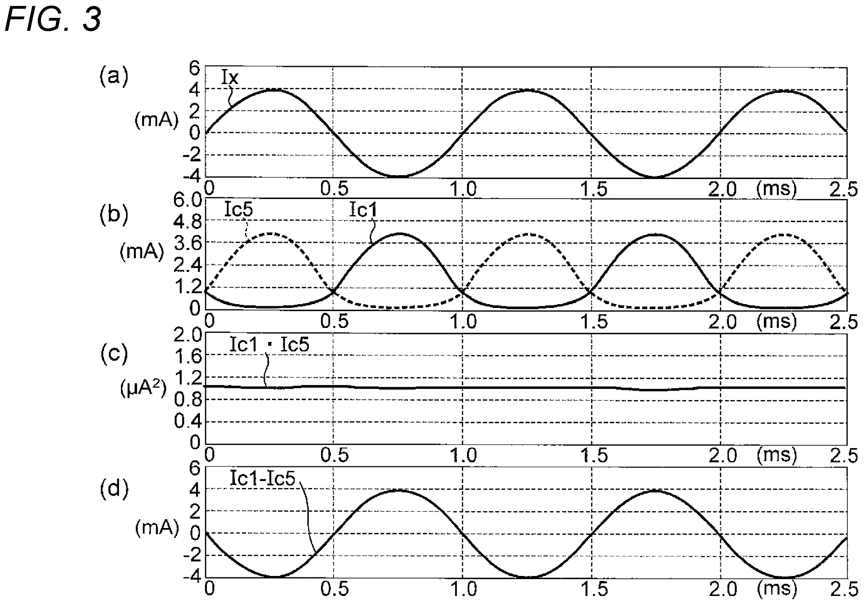

In Fig. 3, (a) to (d) show waveforms of the currents Ic1 and Ic5 (see (b)), the product (see (c)) of the currents Ic1 and Ic5, and the differential current Ic1 - Ic5 (see (d)) in the case where, in the embodiment, the current Id of the constant current source 101 is 1 mA, and a sinusoidal current of ± 4 mA (see (a)) is input as the input signal Ix. As shown in (c) of Fig. 3, the product of the currents Ic1 and Ic5 has a constant value (Id$^2$ = 1 μA). Moreover, it is seen that the differential current Ic 1 - Ic5 becomes a sinusoidal current of ± 4 mA, and is strictly proportional to the input signal Ix.

If the current-current conversion circuit disclosed in JP-A-S62-214707 and JP-A-H8-32367 is applied to the amplification circuit 1A shown in Fig. 1, the following problem arises. In order to allow a current that is proportional to the current flowing through a NPN transistor on the higher potential side to flow between the positive power supply V(+) and the output terminal 208, it is required to dispose a first current mirror circuit that is connected to the positive power supply V(+), and that outputs a current which is proportional to the collector current of the NPN transistor, and a second current mirror circuit that is connected to the positive power supply V(+), and that allows a current which is proportional to the output current of the first current mirror circuit, to flow between the positive power supply V(+) and the output terminal 208.

On the other hands, in order to allow a current that is proportional to the current flowing through a PNP transistor on the lower potential side to flow between the negative power supply V(-) and the output terminal 208, it is required to dispose a third current mirror circuit that is connected to the negative power supply V(-), and that outputs a current which is proportional to the collector current of the PNP transistor, a fourth current mirror circuit that is connected to the positive power supply V(+), and that outputs a current which is proportional to the output current of the third current mirror circuit, and a fifth current mirror circuit that is connected to the negative power supply V(-), and that allows a current which is proportional to the output current of the fourth current mirror circuit, to flow between the output terminal 208 and the negative power supply V(-).

In the case where the current-current conversion circuit disclosed in JP-A-S62-214707 or JP-A-H8-32367 is applied to the amplification circuit 1A shown in Fig. 1 as described above, two set of first and second current mirror circuits are required in order to allow a current to flow through the transistor that is in the output stage, and that is on the side of the positive power supply V(+), and three sets of third to fifth current mirror circuits are required in order to allow a current to flow through the transistor that is on the side of the negative power supply V(-). As a result, there arises a problem that the circuit configuration is asymmetrical, and the characteristics degrade.

In the embodiment, by contrast, the first transistor Q1 and third transistor Q3 in the current-current conversion circuit 100 are transistors of the same polarity. Moreover, the two current mirror circuits 201 and 203 and the other two current mirror circuits 202 and 204 constitute a circuit that is perfectly symmetrical. Therefore, a desired current can be supplied to the transistor that is in the output stage, and that is on the side of the positive power supply V(+), and the transistor that is in the output stage, and that is on the side of the negative power supply V(-), without causing the above-described problem. In the embodiment, the current transmission path extending from the first transistor Q1 to the output terminal 208, and that extending from the third transistor Q3 to the output terminal 208 are not strictly symmetrical because the latter includes the fifth transistor Q5. However, the transistor Q5 constitutes together with the transistor Q3 the translinear circuit. The degree of the degradation of the characteristics of the amplification circuit A1 due to the disposition of the transistor Q5 is very smaller than that of the characteristics of the amplification circuit A1 that is caused by the asymmetry of the current mirror circuits.

In the embodiment, devices ranging from a line device that has a high load impedance (600 Ω to several tens of kΩ), to a speaker that has a low load impedance (about several ohms) can be driven in class A with using a small amount of the idle current by the same amplification circuit 1A.

<Second embodiment>

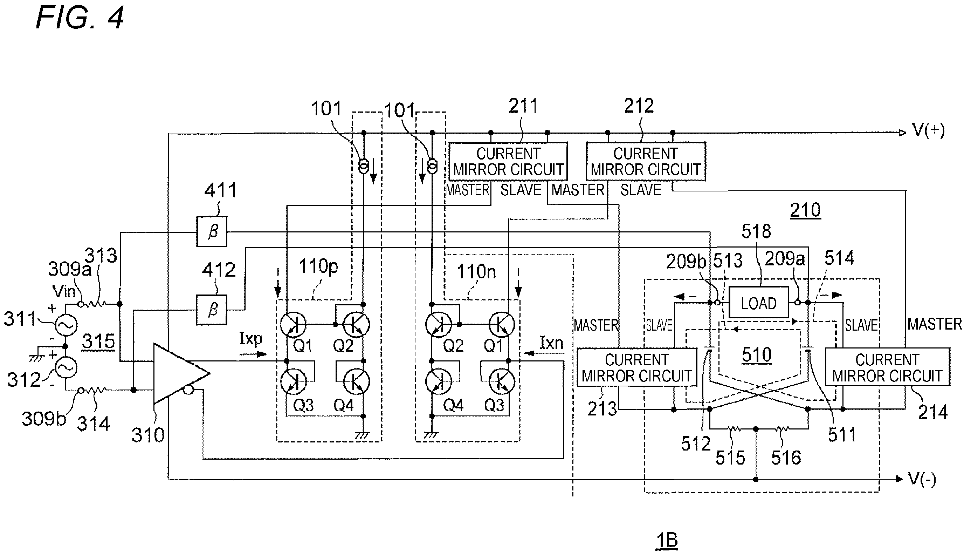

Fig. 4 is a circuit diagram showing the configuration of an amplification circuit 1B of a second embodiment of the invention. In Fig. 4, for the sake of convenience of description, balanced signal sources 311 and 312 that supply a positive phase input signal and a negative phase input signal to input terminals 309a and 309b of the amplification circuit 1B, and a load 518 such as a speaker are illustrated together with the amplification circuit 1B. Both ends of the speaker are connected to output terminals 209a and 209b of the amplification circuit 1B. The amplification circuit 1B has first and second current-current conversion circuits 110p and 110n that are configured in the same manner as the current-current conversion circuit 100 of the first embodiment, a current generation circuit 210, a differential transconductance amplifier 310, and an input circuit 315 that has input resistors 313 and 314 connected respectively to the input terminals 309a and 309b.

The transconductance amplifier 310 differentially amplifies the positive phase input signal that is input from the signal source 311 through the resistor 313, and the negative phase input signal that is input from the signal source 312 through the resistor 314, whereby a positive phase input signal Ixp and negative phase input signal Ixn that are differential current signals are supplied to an input node of the current-current conversion circuit 100p and that of the current-current conversion circuit 100n, respectively.

The current generation circuit 210 has current mirror circuits 211 to 214. These circuits correspond to the current mirror circuits 201 to 204 in the first embodiment. In the current generation circuit 210, the current mirror circuits 211 and 213 function as the first current generating section that supplies a first current between the first output terminal 209a and the second output terminal 209b through a first path including a first floating power supply 511, based on the collector current of the first transistor Q1 of the first current-current conversion circuit 110p. The current mirror circuits 212 and 214 function as the second current generating section that supplies a second current having the polarity opposite to the first current, between the first output terminal 209a and the second output terminal 209b through a second path including a second floating power supply 512, based on the collector current of the first transistor Q1 of the second current-current conversion circuit 110n.

The master side of the current mirror circuit 211 is connected to the collector of the transistor Q1 of the current-current conversion circuit 110p, and the slave side is connected to the master side of the current mirror circuit 213. Therefore, a current that is proportional to the collector current Ic1p of the transistor Q1 of the current-current conversion circuit 110p is supplied to the master side of the current mirror circuit 213.

The master side of the current mirror circuit 212 is connected to the collector of the transistor Q1 of the current-current conversion circuit 110n, and the slave side is connected to the master side of the current mirror circuit 214. Therefore, a current that is proportional to the collector current Ic1n of the transistor Q1 of the current-current conversion circuit 110n is supplied to the master side of the current mirror circuit 214.

In the current generation circuit 210, the slave side of the current mirror circuit 213, that of the current mirror circuit 214, the floating power supplies 511 and 512, and resistors 515 and 516 constitute an output stage circuit 510.

The slave side of the current mirror circuit 213 is connected to the output terminal 209b. The slave side of the current mirror circuit 214 is connected to the output terminal 209a. In the floating power supply 511, the negative terminal is connected to the output terminal 209a, and the positive terminal is connected to the current mirror circuit 213. In the floating power supply 512, the negative terminal is connected to the output terminal 209b, and the positive terminal is connected to the current mirror circuit 214.

The current mirror circuit 213 supplies a first current A·Ic1p that is proportional to the collector current of the transistor Q1 of the current-current conversion circuit 110p, between the output terminals 209a and 209b through a first path including the floating power supply 511. Here, the first path is a path flowing the output terminal 209a, the floating power supply 511, the current mirror circuit 213, and the output terminal 209b in this order. The current mirror circuit 214 supplies a second current A·Ic1n that is proportional to the collector current of the transistor Q1 of the current-current conversion circuit 110n, between the output terminals 209a and 209b through a second path including the floating power supply 512. Here, the second path is a path flowing the output terminal 209b, the floating power supply 512, the current mirror circuit 214, and the output terminal 209a in this order. The second current is a current having the polarity opposite to the first current. Since the load 518 is connected between the output terminals 209a and 209b, two loops are formed. The first loop 513 is a loop including the floating power supply 511, the load 518, and the current mirror circuit 213. The second loop 514 is a loop including the floating power supply 512, the load 518, and the current mirror circuit 214. The first current A·Ic1p flows through the first loop 513, and the second current A·Ic1n flows through the second loop 514.

One end of the resistor 515 is connected to the common connection node of the negative terminal of the floating power supply 511 and the current mirror circuit 213, and the other end is connected to the negative power supply V(-). On end of the resistor 516 is connected to the common connection node of the negative terminal of the floating power supply 512 and the current mirror circuit 214, and the other end is connected to the negative power supply V(-).

The reason why the resistors 515 and 516 are disposed is as follows. A balanced output amplification circuit must be driven so that the potentials of the both ends of a load with respect to the midpoint of the load are always kept symmetric. In the configuration of the amplification circuit 1B, however, the negative terminals of the floating power supplies 511 and 512 are in a completely floating state, and therefore the potential of the midpoint of the load 518 is uncertain. Consequently, the resistors 515 and 516 are disposed at the both ends of the load, and the potential of the common connection node of the resistors is fixed, thereby causing the potentials of the positive terminals of the floating power supplies 511 and 512 to change while always keeping the symmetry with respect to the potential of the midpoint of the load 518.

Because of a feedback circuit 411, the voltage that is generated at the one end of the load 518 is negatively fed back at a feedback factor β to the positive phase input terminal of the transconductance amplifier 310. Because of a feedback circuit 412, moreover, the voltage that is generated at the other end of the load 518 is negatively fed back at a feedback factor β to the negative phase input terminal of the transconductance amplifier 310. Alternatively, each of the feedback circuits 411 and 412 may be configured by a resistor.

The configuration of the amplification circuit 1B has been described above.

In the above-described configuration, the current Ixp that is supplied from the transconductance amplifier 310 to the input node of the current-current conversion circuit 110p, and the current Ixn that is supplied from the transconductance amplifier 310 to the input node of the current-current conversion circuit 110n have the same absolute value but opposite signs. Therefore, the following relationship holds between the collector current Ic1p of the transistors Q1 of the current-current conversion circuit 110p and the collector current Ic1n of the transistor Q1 of the current-current conversion circuit 110n:

$$|Ic1p \cdot Ic1n| = Id^2 \dots (15)$$

Therefore, the currents Ic1p and Ic1n become as follows:

$$Ic1p = \{-Ix + \sqrt{(Ix^2 + 4 \cdot Id^2)}\}/2 \dots (16)$$

$$Ic1n = \{Ix + \sqrt{(Ix^2 + 4 \cdot Id^2)}\}/2 \dots (17)$$

where Ix indicates the absolute values of Ixp and Ixn.

In the embodiment, the current A·Ic1p that is proportional to Ic1p of above equation (16) is supplied to the load 518 through the first loop 513, and the current A·Ic1n that is proportional to Ic1n of above equation (17) is supplied to the load 518 through the second loop 514.

Similarly with the above-described first embodiment, in the amplification operation of the amplification circuit 1B, therefore, the transistors of the output stage, i.e., the transistor that is inserted into the slave side of the current mirror circuit 213, and the transistor that is inserted into the slave side of the current mirror circuit 214 are not cut off, and the amplification circuit 1B operates as a class-A amplification circuit.

Similarly with the above-described first embodiment, also in the embodiment, the relationship between the differential current Ic1p - Ic1n, and the input positive phase signal Ixp or Ixn is indicated by a linear line that passes through the origin. Then, the current A·Ic1p that is proportional to the current Ic1p is flown to the load 518, and the current A·Ic1n that is proportional to the current Icin, and that is opposite in polarity to the current A·Ic1p is flown to the load 518. Therefore, a current A·(Ic1p - Ic1n) that is proportional to the differential current Ic1p - Ic1n is flown to the load 518. According to the embodiment, consequently, it is possible to realize a same-polarity balanced amplifier having high linearity.

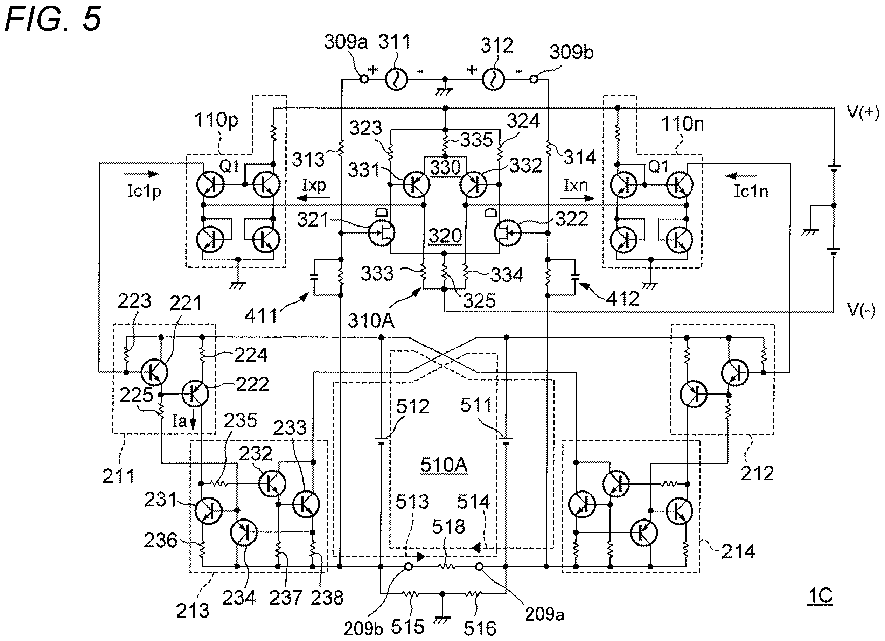

Fig. 5 is a circuit diagram showing the configuration of an amplification circuit 1C that is a first specific example of the amplification circuit 1B. In Fig. 5, portions that are common to the portions shown in Fig. 4 are denoted by the same reference numerals, and their description will be omitted.

In an output stage circuit 510A, the positional relationship between the current mirror circuit 213 and floating power supply 511 in the first loop 513 is reversed to that in the output stage circuit 510, and the positional relationship between the current mirror circuit 214 and floating power supply 512 in the second loop 514 is reversed to that in the output stage circuit 510, whereby the load 518 is moved to a position between the negative terminals of the floating power supplies 511 and 512. However, the output stage circuit 510A is identical in function with the output stage circuit 510 of Fig. 4.

There are various kinds of current mirror circuits. As the current mirror circuit 211, a complementary current mirror circuit that includes a transistor 221 that is an NPN transistor, a transistor 222 that is a PNP transistor, and resistors 223 to 225 is employed. In the transistor 221, the resistor 223 is connected between the collector and the base, the collector is connected to the positive terminal of the floating power supply 512, and the base is connected to the collector of the transistors Q1 of the current-current conversion circuit 110p. In the transistor 222, the emitter is connected to the positive terminal of the floating power supply 512 through the resistor 224, and the base is connected to the emitter of the transistors 221. One end of the resistor 225 is connected to the emitter of the transistor 221.

The current mirror circuit 213 has transistors 231 to 233 that are NPN transistors, a transistor 234 that is a PNP transistor, and resistors 235 to 238. In the transistor 231, the collector is connected to the collector of the transistor 222, the base is connected to the emitter of the transistor 221 through the resistor 225, and the emitter is connected to the negative terminal of the floating power supply 512 through the resistor 236. In the transistor 232, the base is connected to a connection node of the collectors of the transistors 222 and 231 through the resistor 235, the collector is connected to the positive terminal of the floating power supply 511, and the emitter is connected to the negative terminal of the floating power supply 512 through the resistor 237. In the transistor 233, the base is connected to the emitter of the transistor 232, the collector is connected to the positive terminal of the floating power supply 511, and the emitter is connected to the negative terminal of the floating power supply 512 through the resistor 238.

In the current mirror circuit 211, the base-emitter voltage of the transistor 221, and that of the transistor 222 are approximately equal to each other. Therefore, the current Ic1p that flows through the transistor Q1 of the current-current conversion circuit 110p flows through the resistor 223, and, when a voltage is generated across the resistor 223 by the current Ic1p, a voltage that is approximately equal to the generated voltage is generated across the resistor 224. Consequently, a current Ia that is obtained by multiplying the current Ic1p by a coefficient which is determined in accordance with the resistance ratio of the resistors 223 and 224 flows through the transistor 222.

In the current mirror circuit 213, the base of the transistor 231 is connected to the transistor 221 through the resistor 225, and therefore the transistor 231 is turned ON. The current Ia that is output from the transistor 222 flows through the transistor 232 and 231 and the resistor 236. Here, the transistors 231 and 234 constitute a feedback circuit, and their emitter-base voltages are approximately equal to each other. The current that is input to the transistor 232 from the current Ia is controlled so that the voltage that is generated across the resistor 236 by the flowing of the current Ia through the resistor 236, and the voltage that is generated across the resistor 238 by the flowing of the current through the resistor 238 are approximately equal to each other. Therefore, a current that is proportional to the current Ia, i.e., a current that is proportional to the current Ic1p is flown through the resistor 238 through the transistor 233. In this way, the current mirror circuit 213 pulls in the current A·Ic1p that is proportional to the current Ic1p which flows through the current-current conversion circuit 110p, form the floating power supply 511 in the first loop 513.

The current mirror circuit 212 is configured in the same manner as the current mirror circuit 211, and the current mirror circuit 214 is configured in the same manner as the current mirror circuit 213. However, the current mirror circuits 212 and 214 are disposed between the positive and negative terminals of the floating power supply 511 in contrast that the current mirror circuits 211 and 213 are disposed between the positive and negative terminals of the floating power supply 512. Then, the current mirror circuit 214 pulls in the current A·Ic1n that is proportional to the current Ic1n which flows through the current-current conversion circuit 110n, form the floating power supply 512 in the second loop 514.

A transconductance amplifier 310A is a two-stage differential amplifier that has a first stage differential amplifier 320 and a second stage differential amplifier 330. The first stage differential amplifier 320 is configured by N-channel JFETs (Junction Field Effect Transistors) 321 and 322 and resistors 323 to 325. The second stage differential amplifier 330 is configured by transistors 331 and 332 that are PNP transistors, and resistors 333 to 335.

In the first stage differential amplifier 320, the gate of the JFET 321 functions as the positive-phase input terminal of the transconductance amplifier 310A. The positive phase input signal is given from the signal source 311 to the positive-phase input terminal through the resistor 313. The gate of the JFET 322 functions as the negative-phase input terminal of the transconductance amplifier 310A. The negative phase input signal is given from the signal source 312 to the negative-phase input terminal through the resistor 314.

In the second stage differential amplifier 330, the collector of the transistor 331 functions as the positive-phase output terminal of the transconductance amplifier 310A. The transconductance amplifier 310A supplies the positive phase input signal Ixp from the positive-phase output terminal to the current-current conversion circuit 110p. The collector of the transistor 332 functions as the negative-phase output terminal of the transconductance amplifier 310A. The transconductance amplifier 310A supplies the negative-phase input signal Ixn from the negative-phase output terminal to the current-current conversion circuit 110n.

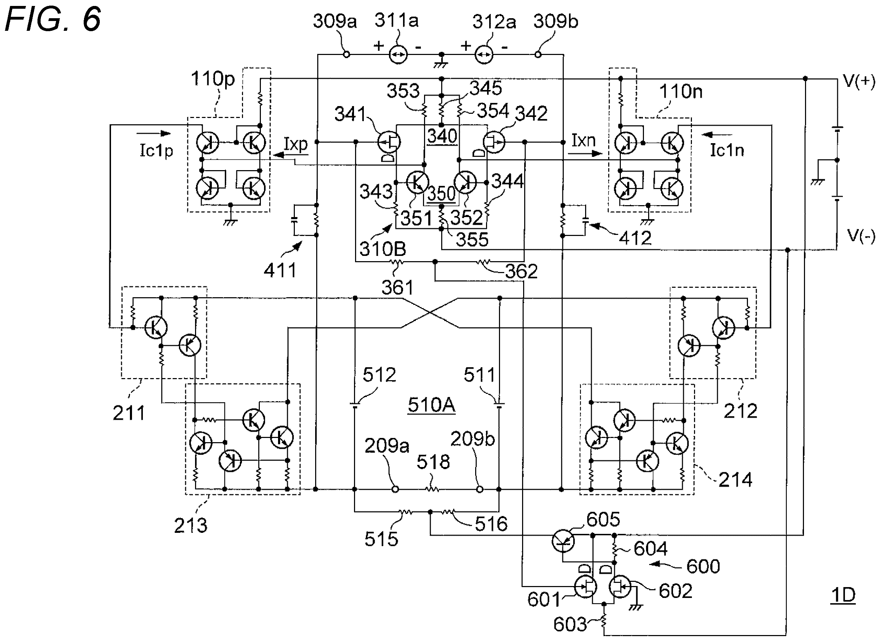

Fig. 6 is a circuit diagram showing the configuration of an amplification circuit 1D that is a second specific example of the amplification circuit 1B. In Fig. 6, portions that are common to the portions shown in Fig. 5 are denoted by the same reference numerals, and their description will be omitted. In the amplification circuit 1D, the signal sources 311 and 312 in Fig. 5 are replaced with signal sources 311a and 312a that are current sources, respectively, and the transconductance amplifier 310A in Fig. 5 is replaced with a transconductance amplifier 310B. Moreover, resistors 361 and 362 and a potential controller 600 are added to the amplification circuit 1D.

The signal sources 311a and 312a are current output DACs (Digital Analogue Converters) that convert a sampled value of, for example, a digital audio signal into a current value, and that output the current value.

The transconductance amplifier 310B is a two-stage differential amplifier that has a first stage differential amplifier 340 and a second stage differential amplifier 350. The first stage differential amplifier 340 is configured by P-channel JFETs 341 and 342 and resistors 343 to 345. The second stage differential amplifier 350 is configured by transistors 351 and 352 that are NPN transistors, and resistors 353 to 355.

In the first stage differential amplifier 340, the gate of the JFET 341 functions as the positive-phase input terminal of the transconductance amplifier 310B. The positive phase input signal (current) is given from the signal source 311a to the positive-phase input terminal. The gate of the JFET 342 functions as the negative-phase input terminal of the transconductance amplifier 310B. The negative phase input signal (current) is given from the signal source 312a to the negative-phase input terminal.

In the second stage differential amplifier 350, the collector of the transistor 351 functions as the positive-phase output terminal of the transconductance amplifier 310B. The transconductance amplifier 310B supplies the positive phase input signal Ixp from the positive-phase output terminal to the current-current conversion circuit 110p. The collector of the transistor 352 functions as the negative-phase output terminal of the transconductance amplifier 310B. The transconductance amplifier 310B supplies the negative-phase input signal Ixn from the negative-phase output terminal to the current-current conversion circuit 110n.

The resistors 361 and 362 are connected in series between the gates of the JFETs 341 and 342. The neutral point potential between the gates of the JFETs 341 and 342 is obtained from the common connection node of the resistors 361 and 362.

The potential controller 600 is a circuit for controlling the potential of the common connection node of the resistors 515 and 516. The reason why the potential controller 600 is disposed is as follows. In the circuit shown in Fig. 5, the floating power supplies 511 and 512 of the output stage circuit 510A are floated, and therefore the current that is supplied, for example, from the grounded current-current conversion circuit 110p to the output stage circuit 510A flows back to the ground through the resistor 516. In the case where the load 518 having a low resistance is driven with large amplitude, therefore, the voltage corresponding to the current flowing through the resistor 516 appears in the output voltage for the load 518, and, in accordance with this, also the input potential of the transconductance amplifier 310A varies.

The varying potential appears in phase at the positive and negative phase input terminals of the transconductance amplifier 310A, and therefore the differential signal that is output from the transconductance amplifier 310A is not affected. In the amplification circuit 1D of Fig. 6, however, the current output DACs that function as the signal sources 311a and 312a are usually designed so as to supply a current to a virtual ground, and therefore it is not preferred from the viewpoint of operation that the input potential of the transconductance amplifier 310B is largely varied.

Moreover, the varying potential contains DC components of the currents that are supplied from the current-current conversion circuits 110p and 110n to the output stage circuit 510A, and equally appears at the positive side output that is one end of the load 518, and the negative side output that is the other end. A headphone or a speaker is operated by a differential output irrespective of the ground potential, and therefore does not suffer the problem of a DC component. In the case of a line output, however, a device is operated by the ground potential, and therefore there arises the problem of a DC component.

Therefore, the potential controller 600 is provided on the amplification circuit 1D shown in Fig. 6. The potential controller 600 controls the midpoint between the positive and negative phase input terminals of the transconductance amplifier 310A so as to be always at the virtual ground.

The potential controller 600 has N-channel JFETs 601 and 602, resistors 603 and 604, and a transistor 605 that is a PNP transistor. In the transistor 605, the emitter is connected to the positive power supply V(+), and the collector is connected to the common connection node of the resistors 515 and 516. The sources of the JFETs 601 and 602 are commonly connected to each other. The resistor 603 is connected between the common connection node and the negative power supply V(-). The drain of the JFET 601 is connected to the positive power supply V(+), and that of the JFET 602 is connected to the positive power supply V(+) through the resistor 604. The base of the transistor 605 is connected to the drain of the JFET 602. The gate of the JFET 602 is grounded, and that of the JFET 601 is connected to the common connection node of the resistors 361 and 362.

In the configuration, the JFETs 601 and 602 and the resistors 603 and 604 constitute a differential amplifier. According to the configuration, when the potential of the common connection node of the resistors 361 and 362 is raised from the ground potential, the current flowing through the resistor 604 is decreased, and the potential of the common connection node of the resistors 515 and 516 is lowered. This causes the potential of the common connection node of the resistors 361 and 362 to be lowered. By contrast, when the potential of the common connection node of the resistors 361 and 362 is lowered from the ground potential, the current flowing through the resistor 604 is increased, and the potential of the common connection node of the resistors 515 and 516 is raised. This causes the potential of the common connection node of the resistors 361 and 362 to be raised. When such a control is conducted, the potential of the common connection node of the resistors 361 and 362 is maintained at the ground potential.

In the case where current output DACs are used as the signal sources 311a and 312a, the transconductance amplifier 310B must be in a state where the positive and negative phase input terminals are virtually grounded. In the amplification circuit 1D, the potential controller 600 maintains the potential of the common connection node of the resistors 361 and 362 at the ground potential, and the request can be satisfied.

According to the amplification circuit 1D, the output currents of the current output DACs are voltage-converted to drive the load, and therefore can directly drive a load having a wide impedance bandwidth, such as a balanced line output, a balanced type headphone, or a speaker.

Usually, the output currents of current output DACs are amplified to the line level, and further amplified by a dedicated amplifier that is suitable for a headphone or a speaker, and the resulting outputs drive such a device. When the amplification circuit 1D is used, however, devices ranging from a line apparatus with a high load impedance (600 $\Omega$ to several tens of k$\Omega$), to a speaker with a low load impedance (about several ohms) can be driven in class A with using a small amount of the idle current by the same amplification circuit 1D while voltage-converting the output currents of current output DACs.

In the case where the output currents of the current output DACs contain a DC component, a constant current circuit for offsetting the DC component must be appropriately placed immediately before the input.

<Other embodiments>

Although the embodiments of the invention have been described above, other embodiments may be made in the invention. For example, following embodiments will be made.

(1) In the first embodiment (Fig. 1), the positive power supply V(+) and the negative power supply V(-) may be replaced with each other, and the transistors Q1 to Q5 may be changed to PNP transistors.

(2) In the second embodiment (Fig. 4), the positive power supply V(+) and the negative power supply V(-) may be replaced with each other, and the transistors Q1 to Q4 in the current-current conversion circuits 110p and 110n may be changed to PNP transistors.

(3) In the amplification circuit 1C of Fig. 5, the first stage of the transconductance amplifier 310A is configured by a differential circuit using N-channel JFETs, and the second stage is configured by a differential circuit using PNP transistors. Alternatively, the first stage may be configured by a differential circuit using P-channel JFETs, and the second stage is configured by a differential circuit using NPN transistors.

(4) In the amplification circuit 1D of Fig. 6, the first stage of the transconductance amplifier 310B is configured by a differential circuit using P-channel JFETs, and the second stage is configured by a differential circuit using NPN transistors. Alternatively, the first stage may be configured by using N-channel JFETs, and the second stage is configured by using PNP transistors.

(5) The potential controller 600 shown in Fig. 6 controls the potential of the common connection node of the resistors 515 and 516 based on the potential of the midpoint between the positive and negative phase input terminals of the transconductance amplifier 310B, thereby controlling the potential of the midpoint between the positive and negative phase input terminals of the transconductance amplifier 310B, to the virtual ground potential. In place of the above-described control, the potential of the common connection node of the resistors 515 and 516 may be controlled based on the potential of the common connection node of the resistors 515 and 516, thereby controlling the potential of the midpoint between the positive and negative phase input terminals of the transconductance amplifier 31 0B, to the virtual ground potential.

(6) Although, in the second embodiment, the current generation circuit 210 supplies the first and second currents to the load 518 based on the collector currents of the transistors Q1 of the current-current conversion circuits 110p and 110n, the current generation circuit may supply the first and second currents to the load 518 based on the collector currents of the transistors Q3 of the current-current conversion circuits 110p and 110n.

(7) The current-current conversion circuit disclosed by JP-A-S62-214707 or JP-A-H8-32367 may be used as the current-current conversion circuits 110p and 110n in the second embodiment. Similarly with the second embodiment, the amplification circuit has first and second current-current conversion circuits in which first and second anti-phase input signals are given to respective input nodes. Each of the current-current conversion circuits has first to fourth transistors and a constant current source. For example, the first transistor is an NPN transistor. The second transistor has a same polarity as the first transistor, and its base is connected to the base of the first transistor. The third transistor is a transistor that has the polarity opposite to the first transistor, such as a PNP transistor, and its emitter is connected to the emitter of the first transistor. The fourth transistor is a transistor that has the polarity opposite to the first transistor, its base is connected to the base of the third transistor, and its emitter is connected to the emitter of the second transistor. The constant current source is connected in series to the second transistor and the fourth transistor. In the current-current conversion circuit, the base and collector of the first transistor (in the case of JP-A-H8-32367) or the second transistor (in the case of JP-A-S62-214707) are connected to each other, the base and collector of the fourth transistor are connected to each other, and the connection node of the first and third transistors is used as an input node. The first current generating section supplies the first current between the first and second output terminals through the first path including the first floating power supply, based on the collector current of the first or third transistor of the first current-current conversion circuit. The second current generation circuit supplies the second current having the polarity opposite to the first current, between the first and second output terminals through the second path including the second floating power supply, based on the collector current of the first or third transistor of the second current-current conversion circuit. Also this mode attains effects similar to the second embodiment.

DESCRIPTION OF REFERENCE NUMERALS AND SIGNS

100, 110p, 110n ...... current-current conversion circuit, 200, 210 ...... current generation circuit, 300, 310, 310A, 310B ...... transconductance amplifier, 400, 411, 412 ...... feedback circuit, Q1 to Q5, 221, 222, 231 to 234, 331, 332, 351, 352, 605 ...... transistor, 201 to 204, 211 to 214 ...... current mirror circuit, 510 ...... output stage circuit, 518 ...... load, 511, 512 ...... floating power supply, 513 ...... first loop, 514 ...... second loop, 315 ...... input circuit, 311, 312,311a,312a ...... signal source, 313,314 ...... input resistor, 101 ...... constant current source, 515, 516, 323 to 325, 333 to 335, 343 to 345, 353 to 355, 223 to 225, 235 to 237 ...... resistor, 1A, 1B 1C, 1D ...... amplification circuit, 320, 340 ...... first stage differential amplifier, 330, 350 ...... second stage differential amplifier, 321, 322, 341, 342, 601, 602 ...... JFET, 309a, 309b ...... input terminal, 209a, 209b ...... output terminal.

**Claims**

1.  An amplification circuit comprising:

    a first current-current conversion circuit (100) including:

       a first transistor (Q1);
       a second transistor (Q2) that has a same polarity as the first transistor (Q1), a collector and a base of the second transistor (Q2) being connected to a base of the first transistor (Q1);
       a third transistor (Q3) that has the same polarity as the first transistor (Q1), a collector and a base of the third transistor (Q3) being connected to an emitter of the first transistor (Q1) to form a connection node;
       a fourth transistor (Q4) that has the same polarity as the first transistor (Q1), a collector and a base of the fourth transistor (Q4) being connected to an emitter of the second transistor (Q2); and
       a constant current source (101) that is connected in series to the second transistor (Q2) and the fourth transistor (Q4),
       wherein the connection node of the first transistor (Q1) and the third transistor (Q3) is connected to receive an input signal (Ix, Ixp); and

    a current generation circuit (200) including:

       a first current generating section comprising first and second current mirror circuits (201, 203), wherein the master side of the first current mirror circuit (201) is connected to the collector of the first transistor (Q1) and the slave side of the first current mirror circuit (201) is connected to the master side of the second current mirror circuit (203), to supply a first current to a load (208) based on a collector current of the first transistor (Q1); and

a second current generating section comprising a fifth transistor (Q5) having the same polarity as the third transistor, the bases of the third and the fifth transistors (Q3, Q5) being connected to each other, the emitters of the third and the fifth transistors (Q3, Q5) being connected to each other, and third and fourth current mirror circuits (202, 204), wherein the master side of the third current mirror circuit (202) is connected to the collector of the fifth transistor (Q5) and the slave side of the third current mirror circuit (202 is connected to the master side of the fourth current mirror circuit (204), to supply a second current to the load (208, 518) based on the collector current of the third transistor (Q3).

2. The amplification circuit according to claim 1, wherein the first current generating section (203) generates the first current between an output terminal (208) to which the load is connected, and a first power supply, and the second current generating section (204) generates the second current between the output terminal (208) and a second power supply.

3. An amplification circuit comprising:

a first current-current conversion circuit (110p) including:

a first transistor (110p-Q1);
a second transistor (110p-Q2) that has a same polarity as the first transistor (110p-Q1), a collector and a base of the second transistor (110p-Q2) being connected to a base of the first transistor (110p-Q1);
a third transistor (110p-Q3) that has the same polarity as the first transistor (110p-Q1), a collector and a base of the third transistor (110p-Q3) being connected to an emitter of the first transistor (110p-Q1) to form a connection node;
a fourth transistor (110p-Q4) that has the same polarity as the first transistor (110p-Q1), a collector and a base of the fourth transistor (110p-Q4) being connected to an emitter of the second transistor (110p-Q2); and
a constant current source (110p-101) that is connected in series to the second transistor (110p-Q2) and the fourth transistor (110p-Q4);
wherein the connection node of the first transistor (110p-Q1) and the third transistor (110p-Q3) is connected to receive an input signal (Ixp);

a second current-current conversion circuit (110n) including:

a first transistor (110n-Q1);
a second transistor (110n-Q2) that has a same polarity as the first transistor (110n-Q1) of the second current-current conversion circuit, a collector and a base of the second transistor of the second current-current conversion circuit (110n) being connected to a base of the first transistor of the second current-current conversion circuit (110n);
a third transistor (110n-Q3) that has the same polarity as the first transistor (110n-Q1) of the second current-current conversion circuit (110n), a collector and a base of the third transistor (110n-Q3) of the second current conversion circuit (110n) being connected to an emitter of the first transistor (110n-Q1) of the second current-current conversion circuit (110n) to form a connection node;
a fourth transistor (110n-Q4) that has the same polarity as the first transistor (110n-Q1) of the second current-current conversion circuit (110n), a collector and a base of the fourth transistor (110n-Q4) of the second current-current conversion circuit (110n) being connected to an emitter of the second transistor (110n-Q2) of the second current-current conversion circuit (110n); and
a constant current source (110n-101) that is connected in series to the second transistor (110n-Q2) of the second current-current conversion circuit (110n) and the fourth transistor (110n-Q4) of the second current-current conversion circuit (110n), a second input signal (Ixn) being applied to the connection node of the first transistor (110n-Q1) of the second current-current conversion circuit (110n) and the third transistor (110n-Q3) of the second current-current conversion circuit (110n);

wherein the first input signal (Ixp) is reversed in phase with respect to the second input signal (Ixn);
the amplification circuit further comprising

a first current generating section comprising first and second current mirror circuits (211, 213), wherein the master side of the first current mirror circuit (211) is connected to the collector of the first transistor (110p-Q1) of the first current-current conversion circuit (110p) and the slave side of the first current mirror circuit (211) is connected to the master side of the second current mirror circuit (213), to supply a first current between a first output terminal (209a) and a second output terminal (209b) through a first path including a first floating power supply (511), based on the collector current of the first transistor (110p-Q1) of the first current-current conversion circuit (110p); and

a second current generation section comprising third and fourth current mirror circuits (212, 214), wherein the master side of the third current mirror circuit (212) is connected to the collector of the first transistor (110n-Q1) of the second current-current conversion circuit (110n) and the slave side of the third current mirror circuit is connected to the master side of the fourth current mirror circuit (214), to supply a second current having a polarity opposite to the first current, between the first output terminal (209a) and the second output terminal (209b) through a second path including a second floating power supply (512), based on the collector current of the first transistor (110n-Q1) of the second current-current conversion circuit (110n).

## Patentansprüche

1.  Verstärkerschaltung, umfassend:
    eine erste Strom-Strom-Wandlerschaltung (100), einschließend:

    einen ersten Transistor (Q1);
    einen zweiten Transistor (Q2), der die gleiche Polarität wie der erste Transistor (Q1) aufweist, wobei ein Kollektor und eine Basis des zweiten Transistors (Q2) mit einer Basis des ersten Transistors (Q1) verbunden sind;
    einen dritten Transistor (Q3), der die gleiche Polarität wie der erste Transistor (Q1) aufweist, wobei ein Kollektor und eine Basis des dritten Transistors (Q3) mit einem Emitter des ersten Transistors (Q1) verbunden sind, um einen Verbindungsknoten zu bilden;
    einen vierten Transistor (Q4), der die gleiche Polarität wie der erste Transistor (Q1) aufweist, wobei ein Kollektor und eine Basis des vierten Transistors (Q4) mit einem Emitter des zweiten Transistors (Q2) verbunden sind; und
    eine Konstantstromquelle (101), die in Reihe mit dem zweiten Transistor (Q2) und dem vierten Transistor (Q4) verbunden ist,
wobei der Verbindungsknoten des ersten Transistors (Q1) und des dritten Transistors (Q3) verbunden ist, um ein Eingangssignal (Ix, Ixp) zu empfangen; und
eine Stromerzeugungsschaltung (200), einschließend:

    einen ersten Stromerzeugungsabschnitt, der erste und zweite Stromspiegelschaltungen (201, 203) umfasst, wobei die Master-Seite der ersten Stromspiegelschaltung (201) mit dem Kollektor des ersten Transistors (Q1) verbunden ist und die Slave-Seite der ersten Stromspiegelschaltung (201) mit der Master-Seite der zweiten Stromspiegelschaltung (203) verbunden ist, um einen ersten Strom an eine Last (208) auf der Grundlage eines Kollektorstroms des ersten Transistors (Q1) zu liefern; und
    einen zweiten Stromerzeugungsabschnitt, der einen fünften Transistor (Q5) umfasst, der die gleiche Polarität wie der dritte Transistor aufweist, wobei die Basen des dritten und des fünften Transistors (Q3, Q5) miteinander verbunden sind, die Emitter des dritten und des fünften Transistors (Q3, Q5) miteinander verbunden sind, und dritte und vierte Stromspiegelschaltungen (202, 204), wobei die Master-Seite der dritten Stromspiegelschaltung (202) mit dem Kollektor des fünften Transistors (Q5) verbunden ist und die Slave-Seite der dritten Stromspiegelschaltung (202) mit der Master-Seite der vierten Stromspiegelschaltung (204) verbunden ist, um einen zweiten Strom an die Last (208, 518) auf der Grundlage des Kollektorstroms des dritten Transistors (Q3) zu liefern.

2.  Verstärkerschaltung nach Anspruch 1, wobei der erste Stromerzeugungsabschnitt (203) den ersten Strom zwischen einem Ausgangsanschluss (208), mit dem die Last verbunden ist, und einer ersten Stromversorgung erzeugt, und der zweite Stromerzeugungsabschnitt (204) den zweiten Strom zwischen dem Ausgangsanschluss (208) und einer zweiten Stromversorgung erzeugt.

3.  Verstärkerschaltung, umfassend:
    eine erste Strom-Strom-Wandlerschaltung (110p), einschließend:

    einen ersten Transistor (110p-Q1);
    einen zweiten Transistor (110p-Q2), der die gleiche Polarität wie der erste Transistor (110p-Q1) aufweist, wobei ein Kollektor und eine Basis des zweiten Transistors (110p-Q2) mit einer Basis des ersten Transistors (110p-Q1) verbunden sind;

einen dritten Transistor (110p-Q3), der die gleiche Polarität wie der erste Transistor (110p-Q1) aufweist, wobei ein Kollektor und eine Basis des dritten Transistors (110p-Q3) mit einem Emitter des ersten Transistors (110p-Q1) verbunden sind, um einen Verbindungsknoten zu bilden;

einen vierten Transistor (110p-Q4), der die gleiche Polarität wie der erste Transistor (110p-Q1) aufweist, wobei ein Kollektor und eine Basis des vierten Transistors (110p-Q4) mit einem Emitter des zweiten Transistors (110p-Q2) verbunden sind; und

eine Konstantstromquelle (110p-101), die in Reihe mit dem zweiten Transistor (110p-Q2) und dem vierten Transistor (110p-Q4) verbunden ist;

wobei der Verbindungsknoten des ersten Transistors (110p-Q1) und des dritten Transistors (110p-Q3) verbunden ist, um ein Eingangssignal (Ixp) zu empfangen;

eine zweite Strom-Strom-Wandlerschaltung (110n), einschließend:

einen ersten Transistor (110n-Q1);

einen zweiten Transistor (110n-Q2), der die gleiche Polarität wie der erste Transistor (110n-Q1) der zweiten Strom-Strom-Wandlerschaltung aufweist, wobei ein Kollektor und eine Basis des zweiten Transistors der zweiten Strom-Strom-Wandlerschaltung (110n) mit einer Basis des ersten Transistors der zweiten Strom-Strom-Wandlerschaltung (110n) verbunden sind;

einen dritten Transistor (110n-Q3), der die gleiche Polarität wie der erste Transistor (110n-Q1) der zweiten Strom-Strom-Wandlerschaltung (110n) aufweist, wobei ein Kollektor und eine Basis des dritten Transistors (110n-Q3) der zweiten Strom-Wandlerschaltung (110n) mit einem Emitter des ersten Transistors (110n-Q1) der zweiten Strom-Strom-Wandlerschaltung (110n) verbunden sind, um einen Verbindungsknoten zu bilden;

einen vierten Transistor (110n-Q4), der die gleiche Polarität wie der erste Transistor (110n-Q1) der zweiten Strom-Strom-Wandlerschaltung (110n) aufweist, wobei ein Kollektor und eine Basis des vierten Transistors (110n-Q4) der zweiten Strom-Strom-Wandlerschaltung (110n) mit einem Emitter des zweiten Transistors (110n-Q2) der zweiten Strom-Strom-Wandlerschaltung (110n) verbunden sind; und

eine Konstantstromquelle (110n-101), die in Reihe mit dem zweiten Transistor (110n-Q2) der zweiten Strom-Strom-Wandlerschaltung (110n) und dem vierten Transistor (110n-Q4) der zweiten Strom-Strom-Wandlerschaltung (110n) verbunden ist, wobei ein zweites Eingangssignal (Ixn) an den Verbindungsknoten des ersten Transistors (110n-Q1) der zweiten Strom-Strom-Wandlerschaltung (110n) und des dritten Transistors (110n-Q3) der zweiten Strom-Strom-Wandlerschaltung (110n) angelegt wird;

wobei das erste Eingangssignal (Ixp) in Bezug auf das zweite Eingangssignal (Ixn) phasenumgekehrt ist;

wobei die Verstärkungsschaltung weiter Folgendes umfasst

einen ersten Stromerzeugungsabschnitt, der erste und zweite Stromspiegelschaltungen (211, 213) umfasst, wobei die Master-Seite der ersten Stromspiegelschaltung (211) mit dem Kollektor des ersten Transistors (110p-Q1) der ersten Strom-Strom-Wandlerschaltung (110p) verbunden ist und die Slave-Seite der ersten Stromspiegelschaltung (211) mit der Master-Seite der zweiten Stromspiegelschaltung (213) verbunden ist, um einen ersten Strom zwischen einem ersten Ausgangsanschluss (209a) und einem zweiten Ausgangsanschluss (209b) über einen ersten Pfad, der eine erste erdungsfreie Stromversorgung (511) einschließt, auf der Grundlage des Kollektorstroms des ersten Transistors (110p-Q1) der ersten Strom-Strom-Wandlerschaltung (110p) zu liefern; und

einen zweiten Stromerzeugungsabschnitt, der dritte und vierte Stromspiegelschaltungen (212, 214) umfasst, wobei die Master-Seite der dritten Stromspiegelschaltung (212) mit dem Kollektor des ersten Transistors (110n-Q1) der zweiten Strom-Strom-Wandlerschaltung (110n) verbunden ist und die Slave-Seite der dritten Stromspiegelschaltung mit der Master-Seite der vierten Stromspiegelschaltung (214) verbunden ist, um einen zweiten Strom mit einer dem ersten Strom entgegengesetzten Polarität zwischen dem ersten Ausgangsanschluss (209a) und dem zweiten Ausgangsanschluss (209b) über einen zweiten Pfad, der eine zweite erdungsfreie Stromversorgung (512) einschließt, auf der Grundlage des Kollektorstroms des ersten Transistors (110n-Q1) der zweiten Strom-Strom-Wandlerschaltung (110n) zu liefern.

## Revendications

1.  Circuit d'amplification, comprenant

    un premier circuit de conversion courant-courant (100), comprenant :

    un premier transistor (Q1) ;
    un deuxième transistor (Q2) qui présente la même polarité que le premier transistor (Q1), un collecteur et une base du deuxième transistor (Q2) étant connectés à une base du premier transistor (Q1) ;
    un troisième transistor (Q3) qui présente la même polarité que le premier transistor (Q1), un collecteur et une base du troisième transistor (Q3) étant reliés à un émetteur du premier transistor (Q1) pour former un noeud de connexion ;
    un quatrième transistor (Q4) qui présente la même polarité que le premier transistor (Q1), un collecteur et une base du quatrième transistor (Q4) étant connectés à un émetteur du deuxième transistor (Q2) ; et
    une source de courant constant (101) qui est connectée en série au deuxième transistor (Q2) et au quatrième transistor (Q4), dans lequel le noeud de connexion du premier transistor (Q1) et du troisième transistor (Q3) est connecté pour recevoir un signal d'entrée (Ix, Ixp) ; et

    un circuit de génération de courant (200), comprenant :

    une première section de génération de courant comprenant des premier et deuxième circuits miroirs de courant (201, 203), dans lesquels le côté maître du premier circuit miroir de courant (201) est connecté au collecteur du premier transistor (Q1) et le côté esclave du premier circuit miroir de courant (201) est connecté au côté maître du deuxième circuit miroir de courant (203) dans le but de fournir un premier courant à une charge (208) sur la base d'un courant de collecteur du premier transistor (Q1) ; et
    une deuxième section de génération de courant comprenant un cinquième transistor (Q5) présentant la même polarité que le troisième transistor, les bases des troisième et cinquième transistors (Q3, Q5) étant connectées l'une à l'autre, les émetteurs des troisième et cinquième transistors (Q3, Q5) étant connectés l'un à l'autre, et des troisième et quatrième circuits miroirs de courant (202, 204), dans lequel le côté maître du troisième circuit miroir de courant (202) est connecté au collecteur du cinquième transistor (Q5) et le côté esclave du troisième circuit miroir de courant (202) est connecté au côté maître du quatrième circuit miroir de courant (204), dans le but de fournir un deuxième courant à la charge (208, 518) sur la base du courant de collecteur du troisième transistor (Q3).

2.  Circuit d'amplification selon la revendication 1, dans lequel la première section de génération de courant (203) génère le premier courant entre une borne de sortie (208) à laquelle la charge est connectée et une première alimentation électrique, et la deuxième section de génération de courant (204) génère le deuxième courant entre la borne de sortie (208) et une deuxième alimentation électrique.

3.  Circuit d'amplification, comprenant :

    un premier circuit de conversion courant-courant (110p), comprenant :

    un premier transistor (110p-Q1) ;
    un deuxième transistor (110p-Q2) qui présente la même polarité que le premier transistor (110p-Q1), un collecteur et une base du deuxième transistor (110p-Q2) étant connectés à une base du premier transistor (110p-Q1) ;
    un troisième transistor (110p-Q3) qui présente la même polarité que le premier transistor (110p-Q1), un collecteur et une base du troisième transistor (110p-Q3) étant connectés à un émetteur du premier transistor (110p-Q1) pour former un noeud de connexion ;
    un quatrième transistor (110p-Q4) qui présente la même polarité que le premier transistor (110p-Q1), un collecteur et une base du quatrième transistor (110p-Q4) étant connectés à un émetteur du deuxième transistor (110p-Q2) ; et
    une source de courant constant (110p-101) qui est connectée en série au deuxième transistor (110p-Q2) et au quatrième transistor (110p-Q4) ;
    dans lequel le noeud de connexion du premier transistor (110p-Q1) et du troisième transistor (110p-Q3) est connecté pour recevoir un signal d'entrée (Ixp) ;

    un deuxième circuit de conversion courant-courant (110n) comprenant :

    un premier transistor (110n-Q1) ;
    un deuxième transistor (110n-Q2) qui présente la même polarité que le premier transistor (110n-Q1) du deuxième circuit de conversion courant-courant, un collecteur et une base du deuxième transistor du deuxième circuit de conversion courant-courant (110n) étant connectés à une base du premier transistor du deuxième circuit de conversion courant-courant (110n) ;

un troisième transistor (110n-Q3) qui présente la même polarité que le premier transistor (110n-Q1) du deuxième circuit de conversion courant-courant (110n), un collecteur et une base du troisième transistor (110n-Q3) du deuxième circuit de conversion courant-courant (110n) étant connectés à un émetteur du premier transistor (110n-Q1) du deuxième circuit de conversion courant-courant (110n) pour former un noeud de connexion ;

un quatrième transistor (110n-Q4) qui présente la même polarité que le premier transistor (110n-Q1) du deuxième circuit de conversion courant-courant (110n), un collecteur et une base du quatrième transistor (110n-Q4) du deuxième circuit de conversion courant-courant (110n) étant connectés à un émetteur du deuxième transistor (110n-Q2) du deuxième circuit de conversion courant-courant (110n) ; et

une source de courant constant (110n-101) qui est connectée en série au deuxième transistor (110n-Q2) du deuxième circuit de conversion courant-courant (110n) et au quatrième transistor (110n-Q4) du deuxième circuit de conversion courant-courant (110n), un deuxième signal d'entrée (Ixn) étant appliqué au noeud de connexion du premier transistor (110n-Q1) du deuxième circuit de conversion courant-courant (110n) et au troisième transistor (110n-Q3) du deuxième circuit de conversion courant-courant (110n) ;

dans lequel le premier signal d'entrée (Ixp) est inversé en phase par rapport au deuxième signal d'entrée (Ixn) ;
le circuit d'amplification comprenant en outre :

une première section de génération de courant comprenant des premier et deuxième circuits miroirs de courant (211 , 213), dans lequel le côté maître du premier circuit miroir de courant (211) est connecté au collecteur du premier transistor (110p-Q1) du premier circuit de conversion courant-courant (110p) et le côté esclave du premier circuit miroir de courant (211) est connecté au côté maître du deuxième circuit miroir de courant (213), pour fournir un premier courant entre une première borne de sortie (209a) et une deuxième borne de sortie (209b) à travers un premier chemin comportant une première alimentation électrique flottante (511), sur la base du courant de collecteur du premier transistor (110p-Q1) du premier circuit de conversion courant-courant (110p) ; et

une deuxième section de génération de courant comprenant des troisième et quatrième circuits miroirs de courant (212, 214), dans lequel le côté maître du troisième circuit miroir de courant (212) est connecté au collecteur du premier transistor (110n-Q1) du deuxième circuit de conversion courant-courant (110n) et le côté esclave du troisième circuit miroir de courant est connecté au côté maître du quatrième circuit miroir de courant (214), pour fournir un deuxième courant présentant une polarité opposée à celle du premier courant, entre la première borne de sortie (209a) et la deuxième borne de sortie (209b) à travers un deuxième chemin comportant une deuxième alimentation électrique flottante (512), sur la base du courant de collecteur du premier transistor (110n-Q1) du deuxième circuit de conversion courant-courant (110n).

## FIG. 1

## FIG. 2

FIG. 3

FIG. 4

EP 3 713 082 B1

FIG. 5

EP 3 713 082 B1

21

1C

FIG. 6

EP 3 713 082 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP S62214707 A
- JP H832367 A

**Non-patent literature cited in the description**

- **FABRE A.** WIDEBAND TRANSLINEAR CURRENT CONVERTOR. *ELECTRONICS LETTERS,* 05 March 1984, vol. 20 (6), 241-242